# EUROPÄISCHE PATENTSCHRIFT

(11) **EP 0 945 979 B1**
(45) Veröffentlichungstag und Bekanntmachung des Hinweises auf die Patenterteilung: **27.12.2006**
(21) Anmeldenummer: 99105617.7
(22) Anmeldetag: 19.03.1999
(51) Int. Cl.: H03G 3/30

(54) **Verstärkervorrichtung für ein mobiles TDMA-Funktelefon und mobiles Funktelefon**
Ampifying device for mobile TDMA-telephone and mobile telephone
Dispositif amplificateur pour téléphone mobile du type AMRT et téléphone mobile

(30) Priorität: 21.03.1998 DE 19812488
(43) Veröffentlichungstag der Anmeldung: 29.09.1999
(73) Patentinhaber: ROBERT BOSCH GMBH, 70442 Stuttgart (DE)
(72) Erfinder: Mader, Thomas, 47509 Rheurdt (DE); Kottschlag, Gerhard, 31139 Hildesheim (DE); Pitz, Gerhard, 31139 Hildesheim (DE)

(56) Entgegenhaltungen:
- EP-A- 0 675 605
- EP-A- 1 001 545
- GB-A- 2 326 782
- US-A- 4 598 252
- US-A- 5 170 495
- US-A- 5 182 527
- US-A- 5 278 997
- US-A- 5 369 789

## Beschreibung

### Stand der Technik

Die Erfindung geht davon aus, von einer Verstärkervorrichtung bzw. einem mobilen Funktelefon nach der Gattung der unabhängigen Patentansprüche. Aus der DE-4,291,719 C2 ist bereits eine Verstärkervorrichtung für ein TDMA-Mobilfunktelefon bekannt, bei dem die Stärke der Verstärkung durch ein entsprechendes Steuersignal eingestellt wird. Obwohl auch mehrere Verstärkerstufen vorgesehen sind, ist das Steuersignal nur für eine dieser Verstärkerstufen vorgesehen. Diese Verstärkerstufe muß daher für einen weiten Dynamikbereich regelbar sein.

Aus der US 4598 252 ist eine mehrstufige Leistungsverstärkeranordnung mit selektiv auswählbaren Verstärkungsumstellungen bekannt wobei eine Stufe eine variable Feinstellung der Verstärkung ermöglicht.

### Vorteile der Erfindung

Die erfindungsgemäße Verstärkervorrichtung bzw. das erfindungsgemäße Funktelefon, haben demgegenüber den Vorteil, daß durch zwei Verstärkerstufen denen jeweils ein Steuersignal zuführbar ist, eine besonders gute Unterdrückung von unerwünschten Restsignalen im Ruhebetrieb erzielbar ist. Weiterhin müssen die Verstärkerstufen jeweils nur einen geringen Dynamikbereich abdecken. Die Verstärkerstufen können daher besonders einfach ausgebildet werden, bzw. die Qualität der einzelnen Verstärkerstufen kann verbessert werden.

Vorteilhafte Weiterbildungen und Verbesserungen der Verstärkerstufen nach dem unabhängigen Patentanspruch ergeben sich durch die Maßnahmen der abhängigen Patentansprüche. Besonders einfach wird die erste Verstärkerstufe, wenn sie nur wenige unterschiedliche Verstellungsstufen auffaßt. Weiterhin lassen sich dann die Steuersignale besonders einfach erzeugen. Durch Rückkopplungsmechanismen kann die Stärke des Ausgangssignals genauer eingestellt werden.

### Zeichnungen

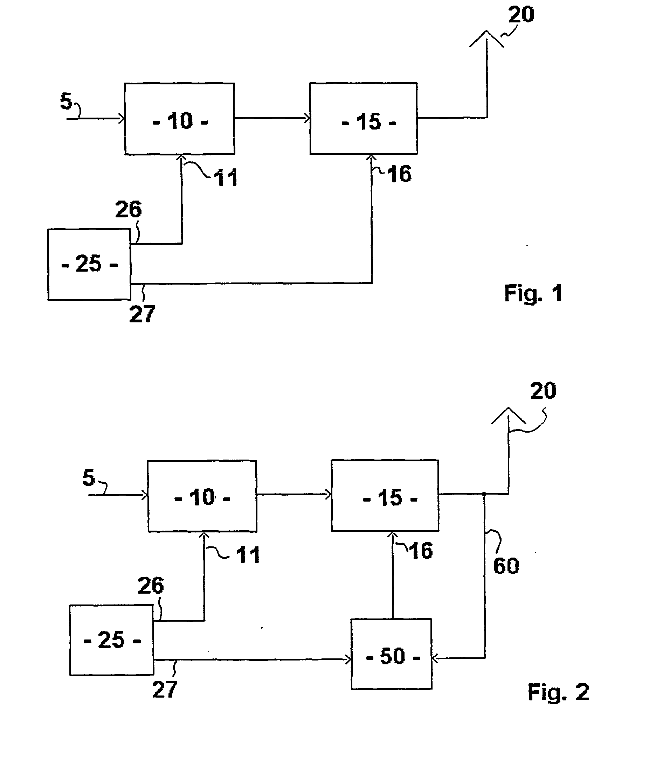

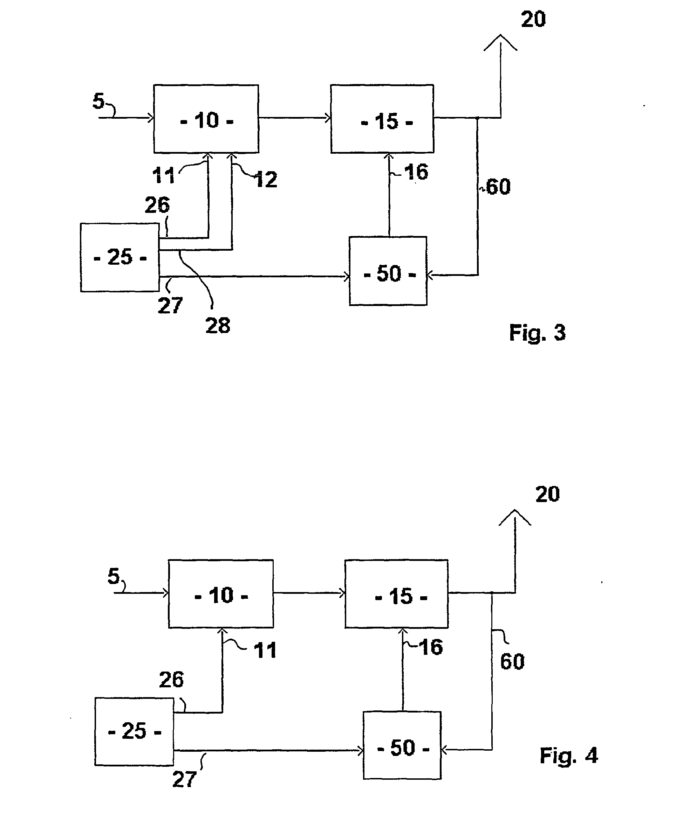

Ausführungsbeispiele sind in den Zeichnungen dargestellt und in der nachfolgenden Beschreibung näher erläutert. Es zeigen die Figuren 1 bis 3 unterschiedliche Ausführungsbeispiele der Erfindung. Die weiteren Figuren 4 bis 6 zeigen Regelschalftweise für Sendeverstärker.

### Beschreibung

In der Figur 1 wird schematisch ein erstes Beispiel für eine erfindungsgemäße Verstärkervorrichtung gezeigt. Die Verstärkervorrichtung weist eine erste Verstärkungsstufe 10 und eine nachgeordnete zweite Verstärkungsstufe 15 auf. Die erste Verstärkungsstufe 10 erhält ein zu verstärkendes Signal über eine Eingangsleitung 5, verstärkt dieses Signal und gibt dann das so verstärkte Signal weiter an die zweite Verstärkungsstufe 15 zur weiteren Verstärkung. Die zweite Verstärkungsstufe 15 verstärkt dieses Signal ebenfalls und gibt es dann über einen Ausgang an die Antenne 20. Neben dem Signaleingang 5 weist die erste Verstärkungsstufe 10 noch einen weiteren Eingang 11 für ein Steuersignal auf. Die zweite Verstärkungsstufe 15 weist ebenfalls einen Eingang 16 für ein Steuersignal auf. Die Steuersignale an den Eingängen 11 und 16 werden durch eine Kontrolleinrichtung 25 erzeugt, die einen ersten Ausgang 26 für das Signal am Eingang 11 und einen zweiten Ausgang 27 für das Signal am Eingang 16 aufweist.

Eine derartige Verstärkungsvorrichtung ist insbesondere für den Einsatz in mobilen Telefonsystemen gedacht, die nach dem TDMA-System (Time Division Multiple Access) arbeiten. Bei derartigen TDMA Mobilfunktelefonen ist jedem Telefon ein Zeitschlitz zugeordnet in dem das Telefon Signale über die Antenne aussendet. Um Störungen von anderen Telefonen zu vermeiden, werden für übrige Zeiten sehr strikte Anforderungen bezüglich der Unterdrückung von Störsignalen gestellt, da sichergestellt werden soll, daß keines der beteiligten Telefone ein Funksignal in einem Zeitschlitz erzeugt, welches einem anderen Telefon zugeordnet ist. An der Antenne 20 soll daher nur während des Zeitschlitzes der dem Telefon zugeordnet ist, ein Trägersignal ausgesendet werden, während das Trägersignal in der übrigen Zeit unterdrückt werden muß. Weiterhin muß die an der Antenne 20 abgestrahlte Leistung in Abhängigkeit der Dämpfungen der Übertragungsstrecke zwischen Mobiltelefon und Basisstation genau eingestellt werden. Ausgehend von einem Ruhezustand in dem die Verstärkungsstufen 10, 15 kein Signal abgeben dürfen (Dämpfung in der Größenordnung von -20 dB) wird die Verstärkung der Verstärkungsstufen 10, 15 zu Beginn eines Sendezeitschlitzes definiert erhöht. Auch in der Zeit, in der das Mobiltelefon keine Signale aussenden darf, liegt am Eingang 5 ein Trägersignal, Rauschen oder dergleichen an, was nicht verstärkter bzw. gut gedämpft werden soll (Dämpfung in der Größenordnung von -20 dB). Durch Erhöhung der Verstärkung der Verstärkungsstufen 10, 15 am Anfang des Sendezeitschlitzes wird dann die Verstärkungsvorrichtung zur Übertragung von Daten vorbereitet. Wenn die Gesamtverstärkung der Verstärkerstufen 10, 15 den vorgegebenen Sollwert erreicht hat, können Daten übertragen werden. Das Hochfahren der Verstärkung kann dabei nicht schlagartig erfolgen, da bei einem zu schnellen Anstieg der Verstärkung nicht verhindert werden kann, daß unzulässig hohe Spektalanteile in benachbarte Frequenzbereiche abgestrahlt werden. Das Hochfahren der Verstärker muß daher in definierter Weise erfolgen.

Erfindungsgemäß wird nun in dem Ausführungsbeispiel nach der Figur 1 vorgesehen, daß die Kontrolleinrichtung am Ausgang 26 ein digitales Kontrollsignal abgibt durch das die erste Verstärkungsstufe 10 mit einer festen vorgegebenen Verstärkung eingeschaltet wird. Am Ausgang 27 der Steuervorrichtung 25 wird hingegen ein Analogsignal abgegeben, welches in definierter Weise die Verstärkung der zweiten Verstärkungsstufe 15 hochfährt. Bei einer gewünschten Gesamtverstärkung von beispielsweise 30 dB könnte die fest eingestellte Verstärkung des ersten Verstärkers beispielsweise 10 dB und die des zweiten Verstärkers 20 dB betragen. Vom zeitlichen Verlauf her würden die ersten 10 dB Verstärkung somit sehr schnell eingestellte Werten während die restlichen 20 dB mit zeitlich vorgegebenen Verlauf hochgefahren werden. Durch die Aufteilung der Gesamtverstärkung auf zwei ansteuerbare Verstärkerstufen wird die Dynamik auf zwei Verstärkerstufen verteilt, die dann jeweils für sich entsprechend einfacher ausgelegt sein können. Das Design der Verstärker wird somit vereinfacht und es können so auch besser Dämpfungen im Ruhezustand erzielt werden. Weiterhin muß im vorliegenden Fall nicht ein Verstärker vorgesehen werden, der im gesamten Dynamikbereich kontrolliert aussteuerbar ist. Bei einem einstufigen Verstärker müßte nämlich eine Aussteuerbarkeit über den gesamten Dynamikbereich vorgesehen werden, was den Verstärker entsprechend komplizierter macht.

In der Figur 2 wird eine weiteres Ausführungsbeispiel der Erfindung gezeigt. Die Bezugszahlen 5, 10 ,15, 20 ,25, 26, 27, 11 und 16 bezeichnen wieder die selben Sachverhalte wie in der Figur 1. Das Signal am Ausgang 27 der Steuerung 25 wird jedoch nicht unmittelbar der Verstärkungsstufe 15 zugeordnet sondern einem Regler 50. Dieser Regler 50 ist durch eine Rückkopplungsschleife 60 mit dem Signal an der Antenne 20 rückgekoppelt und produziert in Abhängigkeit von der Signal der Rückkopplungsschleife 60 und dem Signal am Ausgang 27 ein entsprechendes Steuersignal für den Eingang 16 der Verstärkerstufe 15. Durch den Regler 50 wird dabei sichergestellt, daß er die an der Antenne 20 abgestrahlte Leistungen dem Signalpegel entspricht, der durch das Signal am Ausgang 27 vorgegeben ist. Durch den Regler 50 kann somit erreicht werden, daß die tatsächlich an der Antenne 20 anliegende Ausgangsspannung genauer kontrolliert wird, als wenn dies nur durch eine einfache Ansteuerung erfolgt. Neben der bereits zu Figur 1 dargelegten vereinfachten Dynamikanforderung an die Verstärker, werden weitere Vorteile erreicht. Der Verstärker 10 ist besonders einfach ausgebildet. Durch die Regelung können frequenz- und pegelabhängige Fehler der Verstärker gut unterdrückt werden.

In der Figur 3 wird ein weiteres Ausführungsbeispiel der Erfindung gezeigt. Die Bezugsziffern 5, 10, 15, 20, 25, 27, 50, 16 und 60 bezeichnen wieder die gleichen Gegenstände, wie in der Figur 2. Im Unterschied zur Figur 2 weist die erste Verstärkungsstufe 10 jedoch einen ersten Eingang 11 und einen zweiten Eingang 12 auf, die mit entsprechenden Ausgängen 26 und 28 der Steuerung 25 verbunden sind. Die in der Figur 3 gezeigte erste Verstärkerstufe 10 ist hier so ausgelegt, daß durch entsprechende Signale an den Eingängen 11 und 12 zwei unterschiedliche Verstärkungszustände realisiert werden können. Dies sei im folgenden an Hand eines Beispiels erläutert. Außerhalb des Sendezeitschlitzes wird eine Dämpfung von -18 dB gefordert, wobei die erste Verstärkerstufe im ausgeschalteten Zustand, d. h., wenn kein Signal an den Eingängen 11 und 12 anliegt, eine Dämpfung von -18 dB aufweist. Für die Leistung im Sendezeitschlitz soll eine Gesamtverstärkung von 5 bis 33 dB möglich sein. Diese gewünschte Verstärkung wird von der Steuereinrichtung 25 vor dem Zeitschlitz berechnet und wird während des gesamten Zeitschlitzes konstant gehalten. Die Verstärkung der ersten Verstärkerstufe wird durch Anlegen eines Signals am Eingang 11 auf -3 dB und durch Anlegen eines Signals am Eingang 12 auf 15 dB eingestellt. Die erste Verstärkerstufe 10 weist somit drei unterschiedliche Verstärkungszustände auf: -18dB, -3dB und + 15 dB. Die zweite Verstärkerstufe 15 kann zwischen 8 und 18 dB eingestellt werden. Die einzelnen Verstärkerstufen 10, 15 können natürlich hinsichtlich ihrer Nacheinanderanordnung auch vertauscht werden. Im Ruhezustand, d. h. außerhalb des Sendezeitschlitzes weist keines der Ausgänge 26, 27, 28, ein Signal auf. Zu Beginn jedes Zeitschlitzes wird dann entweder ein Signal am Ausgang 26 oder am Ausgang 28 erzeugt, je nach dem welche Gesamtverstärkungen während des Zeitschlitzes realisiert werden soll. Bei einer Gesamtverstärkung zwischen 5 bis 17 dB wird der Eingang 11 und bei einer Gesamtverstärkung von mehr als 17 dB bis 33 dB wird der Eingang 12 der ersten Verstärkerstufe 10 mit einem Signal beaufschlagt. Zeitgleich wird am Ausgang 27 ein Analogsignal erzeugt, welches zeitlich definiert auf einen vorgegebenen Wert ansteigt, um so die Gesamtleistung definiert hochzufahren. Durch ein entsprechendes Signal am Ausgang 27 wird dann die Verstärkung der zweiten Verstärkerstufe 15 auf einen Wert zwischen 8 und 20 dB eingestellt. Mit einer derartigen Vorrichtung lassen sich somit auf einfache Weise Gesamtverstärkungen zwischen 5 und 30 dB jeweils in zwei dB-Abstufungen erzeugen. Bei den Signalen an den Ausgängen 26 und 28 handelt es sich um einfache Digitalsignale, so daß die Steuerung 25 für diese Ausgänge keine Digitalanalogwandler aufweisen muß. Die Signale am Ausgang 27 werden durch ein Digitalanalogwandler erzeugt, wobei der zeitliche Anstieg des Verstärkungssignals von dem gewünschten zeitlichen Verlauf des Anstiegs der gesamten Verstärkung abhängt. Da die zweite Verstärkerstufe 15 jedoch nicht den gesamten Dynamikbereich zwischen 5 und 33 dB der Ausgangsverstärkung durchfahren muß, kann der Digitalanalogwandler entsprechend einfacher ausgelegt sein. Weiterhin ist natürlich auch der Verstärker 15 wesentlich einfacher ausgeführt als ein Verstärker, der den gesamten Dynamikbereich von 5 bis 33 dB abdecken müßte. Neben den Vorteilen wie sie bereits zur Figur 2 erläutert wurden kann hier die Dynamik des zweiten Verstärkers 15 besonders gering sein im Vergleich zur Gesamtdynamik.

In der Figur 4 wird eine Schaltung gezeigt, wobei alle verwendeten Bezugszeichen dem Bezugszeichen in der Figur 2 entsprechen. Im Unterschied zur Figur 2 werden jedoch an den Ausgängen 26 und 27 andere Signale angelegt als er dies zur Figur 2 beschrieben wurde. Auch die Verstärker insbesondere der Verstärker 10 unterscheiden sich daher auch von den Verstärkern nach der Figur 2. An beiden Ausgängen 26 und 27 der Steuerung 25 werden hier Analogsignale ausgegeben. Das Signal am Ausgang 27 enthält hier die Information über die gewünschte Gesamtverstärkung und den gewünschten Anstieg des Signals. Der Verstärker 10 wird hier jedoch mit einem analogen Signals angesteuert und es kann daher die Gesamtverstärkung flexibler auf die beiden Verstärker 10 und 15 verteilt werden. Auch hier ist es so, daß jede Verstärkerstufe für sich nur ein geringen Dynamikbereich abdeckt. Neben der bereits zu Figur 1 dargelegten vereinfachten Dynamikanforderung an die Verstärker, werden weitere Vorteile erreicht. Die Dynamik des zweiten Verstärkers 15 kann besonders gering sein im Vergleich zur Gesamtdynamik. Durch die Regelung können frequenz- und pegelabhängige Fehler der Verstärker gut unterdrückt werden. Weiterhin ist ein sanftes Hoch- und Runterregeln der Leistung über den gesamten Dynamikbereich möglich.

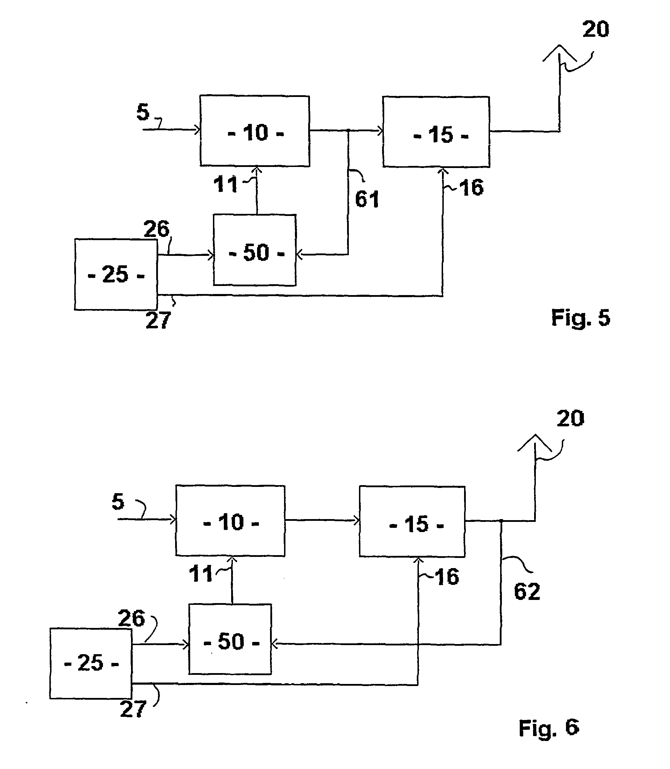

In der Figur 5 wird eine andere Schaltung gezeigt, wobei die Bezugszahlen 15, 20, 25, 26, 27, 11 und 16 wieder die gleichen Gegenstände beschreiben, wie in der Figur 4. Im Unterschied zur Figur 4 ist jedoch die Rückkopplungsschleife nicht für die zweite Verstärkungsstufe 15 sondern für die erste Verstärkungsstufe 10 vorgesehen, wobei die Rückkopplungsschleife 61 ein Signal zwischen den beiden Verstärkungsstufen 10 und 15 abgreift. Am Ausgang 26 wird ein Analogsignal ausgegeben, welches den zeitlichen Verlauf des Hochfahrens der Verstärkung bestimmt. Der zeitliche Verlauf und auch der Endwert während der Sendezeitschlitze ist jedoch bei allen Sendezeitschlitzen gleich, egal welche Gesamtverstärkung für den jeweiligen Zeitschlitz vorgesehen ist. Die Mittel zu Erzeugung dieser Analogspannung können daher besonders einfach sein und beispielsweise durch Analogfilter oder der gleichen gebildet werden. Die Höhe der gesamten Verstärkung wird bei dem Ausführungsbeispiel nach der Figur 4 durch den Analogwert des Ausgangs 27 festgelegt, wobei dieser Wert für die Dauer des gesamten Sendezeitschlitzes konstant gehalten wird. Durch die Rückkopplungsschleife 61 und den Regler 50 wird erreicht, daß das Ausgangssignal der ersten Verstärkungsstufen 10 auf den vorgegebenen Zeitverlauf geregelt wird. Während in der Figur 4 durch die Regelung der Endwert der Verstärkung geregelt wird, wird nach der Figur 5 das Hochfahren der Verstärkung geregelt. Es ist natürlich auch möglich, beide Regelungsmechanismen in einem einzigen Ausführungsbeispiel miteinander zu kombinieren. Neben der bereits zu Figur 1 dargelegten vereinfachten Dynamikanforderung an die Verstärker, werden weitere Vorteile erreicht. Die Dynamik des zweiten Verstärkers 15 kann besonders gering sein im Vergleich zur Gesamtdynamik. Durch die Regelung können frequenz- und pegelabhängige Fehler der Verstärker gut unterdrückt werden. Weiterhin ist ein sanftes Hoch- und Runterregeln der Leistung über den gesamten Dynamikbereich möglich. Dabei ist das Signal für das Hoch- und Runterregeln der Leistung unabhängig vom gewünschten Pegel der Ausgangsleistung, was die Berechnung im Prozessor 25 vereinfacht.

In der Figur 6 wird eine weitere Schaltung gezeigt, bei dem die Bezugsziffern 5, 10, 15, 20, 25, 26, 27, 11, 16 und 50 wieder die gleichen Gegenstände beschreiben, wie zur Figur 5. Im Unterschied zur Figur 5 erfolgt hier jedoch die Rückkopplung des Reglers 50 über eine Rückkopplungsschleife 62, die das Ausgangssignal auf den ersten Verstärker 10 zurückkoppelt. Das Signal 26 berücksichtigt sowohl den zeitlichen Verlauf der Signalanhebung und -absenkung, wie auch die mit dem Signal 27 ausgewählte Gesamtverstärkung. Durch diese Art der Rückkopplung kann nicht nur die Anstiegsgeschwindigkeit kontrolliert werden, sondern auch der für die Dauer des Zeitschlitzes konstant zu haltende Endwert der Verstärkung. Neben der bereits zu Figur 1 dargelegten vereinfachten Dynamikanforderung an die Verstärker, werden weitere Vorteile erreicht. Die Dynamik des zweiten Verstärkers 15 kann besonders gering sein im Vergleich zur Gesamtdynamik. Durch die Regelung können frequenz- und pegelabhängige Fehler der Verstärker gut unterdrückt werden. Weiterhin ist ein sanftes Hoch- und Runterregeln der Leistung über den gesamten Dynamikbereich möglich.

## Patentansprüche

1. Verstärkervorrichtung für ein mobiles Telefon mit mindestens einem Eingang (5) an dem das zu verstärkende Signal anlegbar ist und einem Steuereingang, an dem ein Steuersignal anlegbar ist, wobei durch das Steuersignal ein Verstärkungsfaktor für das zu verstärkende Signal (5) einstellbar ist, und wobei zwei nacheinander angeordnete Verstärkerstufen (10, 15) vorgesehen sind, dass jede Verstärkerstufe (10, 15) einen Steuereingang für ein Steuersignal aufweist, und dass die Gesamtverstärkung durch die Steuersignale an den beiden Steuereingängen (11, 16) einstellbar ist, und wobei eine Kontrolleinrichtung (25) mit einem ersten Ausgang (26) und mit einem zweiten Ausgang (27) vorgesehen ist, die Steuersignale an den Steuereingängen (11, 16) erzeugt, wobei das Steuersignal am Eingang (11) der ersten Verstärkerstufe (10) vom ersten Ausgang (26) der Kontrolleinrichtung (25) und das Steuersignal am Eingang (16) der zweiten Verstärkerstufe (15) vom zweiten Ausgang (27) der Kontrolleinrichtung (25) geliefert wird,
***dadurch gekennzeichnet, dass***
die Kontrolleinrichtung (25) am ersten Ausgang (26) ein digitales Kontrollsignal abgibt, durch das die erste Verstärkerstufe (10) mit einer festen vorgegebenen Verstärkung eingeschaltet wird, und wobei am zweiten Ausgang (27) ein Analogsignal abgegeben wird, welches in definierter Weise die Verstärkung der zweiten Verstärkerstufe (15) mit einem zeitlich gesteuerten Verlauf hochfährt, wobei das Analogsignal zeitlich definiert auf einen vorgegebenen wert ansteigt, um so die Gesamtleistung definiert hochzufahren

2. Verstärkervorrichtung nach Anspruch 1, **dadurch gekennzeichnet, daß** die erste Verstärkerstufe 10 durch ein Steuersignal am Steuereingang (11) auf eine fest vorgegebene Verstärkung einstellbar ist und daß die Verstärkung der zweiten Verstärkerstufen (15) variabel in Abhängigkeit von einem Steuersignal am Steuereingang (16) einstellbar ist.

3. Verstärkervorrichtung nach Anspruch 1 oder 2, **dadurch gekennzeichnet, daß** das Steuersignal der zweiten Verstärkerstufe (15) von einem Regler (50) erzeugt wird, wobei dieses Signal von dem Regler aus einem analogen Steuersignal und einem Rückkopplungssignal, welches aus dem Ausgangssignal der zweiten Verstärkerstufe (15) abgeleitet ist, gebildet wird.

4. Verstärkervorrichtung nach Anspruch 3, **dadurch gekennzeichnet, daß** der Regler (50) mit dem Ausgangssignal der zweiten Verstärkerstufe (15) rückgekoppelt ist.

5. Verstärkervorrichtung nach Anspruch 1, **dadurch gekennzeichnet, daß** eine der Verstärkerstufen (10, 15) mindestens drei unterschiedliche Verstärkungszustände aufweist.

6. Verstärkervorrichtung nach Anspruch 1, **dadurch gekennzeichnet, daß** bei Beginn jedes Zeitschlitzes das Steuersignal für die erste Verstärkerstufe (10) in zeitlich festgelegter Weise auf einen fest vorgegebenen Wert erhöht wird, daß das Steuersignal für die zweite Verstärkerstufe (15) in Abhängigkeit von der für den Zeitschlitz vorgesehenen Gesamtverstärkung eingestellt wird, und daß das Steuersignal für die zweite Verstärkerstufe (15) durch einen Regler (50), der mit dem Ausgangssignal der zweiten Verstärkerstufe (15) rückgekoppelt ist, erzeugt wird.

7. Mobiles Telefon, **dadurch gekennzeichnet, daß** eine Verstärkervorrichtung nach den vorhergehenden Ansprüchen verwendet wird.

## Claims

1. Amplifier apparatus for a mobile telephone having at least one input (5) to which the signal to be amplified can be applied, and a control input to which a control signal can be applied, the control signal being able to set a gain for the signal (5) to be amplified, and two amplifier stages (10, 15) arranged one after another being provided such that each amplifier stage (10, 15) has a control input for a control signal, and that the overall gain can be set by the control signals at the two control inputs (11, 16), and a control device (25) being provided which has a first output (26) and a second output (27) and generates the control signals at the control inputs (11, 16), the control signal at the input (11) of the first amplifier stage (10) being supplied by the first output (26) of the control device (25), and the control signal at the input (16) of the second amplifier stage (15) being supplied by the second output (27) of the control device (25),
**characterized in that**
the control device (25) outputs at the first output (26) a digital control signal by means of which the first amplifier stage (10) is switched in with a fixed prescribable gain, and there is output at the second output (27) an analogue signal which increases the gain of the second amplifier stage (15) in a defined way with a temporally controlled profile, the analogue signal rising to a prescribed value in a temporally defined fashion in order thus to increase the overall power in a defined fashion.

2. Amplifier apparatus according to Claim 1, **characterized in that** the first amplifier stage (10) can be set by a control signal at the control input (11) to a permanently prescribed gain, and **in that** the gain of the second amplifier stage (15) can be set in a variable fashion as a function of a control signal at the control input (16).

3. Amplifier apparatus according to Claim 1 or 2, **characterized in that** the control signal of the second amplifier stage (15) is generated by a controller (50), this signal from the controller being formed from an analogue control signal and a feedback signal which is derived from the output signal of the second amplifier stage (15).

4. Amplifier apparatus according to Claim 3, **characterized in that** the output signal of the second amplifier stage (15) is fed back to the controller (50).

5. Amplifier apparatus according to Claim 1, **characterized in that** one of the amplifier stages (10, 15) has at least three different amplifying states.

6. Amplifier apparatus according to Claim 1, **characterized in that** at the start of each time slot the control signal for the first amplifier stage (10) is increased in a temporally fixed way to a permanently prescribed value, **in that** the control signal for the second amplifier stage (15) is set as a function of the overall gain provided for the time slot, and **in that** the control signal for the second amplifier stage (15) is generated by a controller (50) to which the output signal of the second amplifier stage (15) is fed back.

7. Mobile telephone, **characterized in that** an amplifier apparatus according to the preceding claims is used.

## Revendications

1. Dispositif d'amplification pour un téléphone mobile comprenant au moins une entrée (5) pour recevoir le signal à amplifier et une entrée de commande pour recevoir un signal de commande, le signal de commande permettant de régler un facteur d'amplification pour le signal (5) à amplifier ; deux niveaux d'amplification (10, 15) successifs étant prévus, chacun présentant une entrée de commande pour un signal de commande ; l'amplification totale pouvant être réglée par les signaux de commande aux deux entrées de commande (11, 16), et un dispositif de contrôle (25) qui génère des signaux de commande aux entrées de commande (11, 16)étant prévu avec une première sortie (26) et une deuxième sortie (27), le signal de commande à l'entrée (11) du premier niveau d'amplification (10) étant fourni par la première sortie (26) du dispositif de contrôle (25) et le signal de commande à l'entrée (16) du deuxième niveau d'amplification (15) par la deuxième sortie (27) du dispositif de contrôle (25),
**caractérisé en ce que**
le dispositif de contrôle (25) émet à la première sortie (26) un signal de contrôle numérique qui active le premier niveau d'amplification (10) avec une amplification fixe prédéfinie, et à la deuxième sortie (27) est émis un signal analogique qui démarre de façon définie l'amplification du deuxième niveau d'amplification (15) avec une évolution commandée dans le temps, le signal analogique augmentant de façon définie dans le temps à une valeur prédéfinie pour ainsi atteindre de façon définie la puissance maximale.

2. Dispositif d'amplification selon la revendication 1,
**caractérisé en ce que**
le premier niveau d'amplification (10) peut être réglé par un signal de commande à l'entrée de commande (11) sur une amplification fixe prédéfinie, et l'amplification des deuxièmes niveaux d'amplification (15) peut être réglée de manière variable en fonction d'un signal de commande à l'entrée de commande (16).

3. Dispositif d'amplification selon la revendication 1 ou 2,
**caractérisé en ce que**
le signal de commande du deuxième niveau d'amplification (15) est généré par un régulateur (50), ce signal étant formé par le régulateur à partir d'un signal de commande analogique et d'un signal de réinjection dérivé du signal de sortie du deuxième niveau d'amplification (15).

4. Dispositif d'amplification selon la revendication 3,
**caractérisé en ce que**
le régulateur (50) est relié en réinjection au signal de sortie du deuxième niveau d'amplification (15).

5. Dispositif d'amplification selon la revendication 1,
**caractérisé en ce qu'**
un des niveaux d'amplification (10, 15) présente au moins trois états d'amplification différents.

6. Dispositif d'amplification selon la revendication 1
**caractérisé en ce qu'**
au début de chaque créneau de temps, le signal de commande pour le premier niveau d'amplification (10) est augmenté de manière prédéfinie dans le temps jusqu'à une valeur fixe prédéterminée, le signal de commande pour le deuxième niveau d'amplification (15) est réglé en fonction de l'amplification totale prévue pour le créneau de temps, et le signal de commande pour le deuxième niveau d'amplification (15) est généré par un régulateur (50) relié en réinjection au signal de sortie du deuxième niveau d'amplification (15).

7. Téléphone mobile,
**caractérisé en ce que**
l'on utilise un dispositif d'amplification selon les revendications précédentes.
